# EUROPEAN PATENT SPECIFICATION

(11) **EP 0 700 597 B1**
(45) Date of publication and mention of the grant of the patent: **12.03.2003**
(21) Application number: 94915853.9
(22) Date of filing: 22.04.1994
(51) Int. Cl.: H03F 21/00, H03F 3/45, H03F 3/347, H03F 3/68

(54) **DIFFERENTIAL AUDIO LINE RECEIVER**
DIFFERENTIELLE NIEDERFREQUENZ-LEITUNGSEMPFÄNGER
RECEPTEUR DE LIGNE AUDIO A DIFFERENTIEL

(30) Priority: 22.04.1993 US 50905
(43) Date of publication of application: 13.03.1996
(73) Proprietor: WHITLOCK, William E., Sherman Oaks, CA 91403 (US)
(72) Inventor: WHITLOCK, William E., Sherman Oaks, CA 91403 (US)
(74) Representative: Enskat, Michael Antony Frank
(86) International application number: US9404424
(87) International publication number: WO94024761

(56) References cited:
- US-A- 4 320 351
- US-A- 5 095 282
- US-A- 5 300 896
- MILLMAN ET AL.: "Integrated electronics analog and digital circuits and systems " , MC GRAW-HILL , 1972 XP002077881 *Fig. 8-31(b) * * page 276 - page 278 *
- "Linear Applications Volume 1" , NATIONAL HANDBOOK , 5-1968 XP002077882 * Figure 24 on AN5-10, and AN5-9 *
- National Handbook, "Linear Applications", Volume 1, May 1968, Figure 24 on AN5-10 and AN5-9.
- MILLMAN et al., "Integrated Electronics Analog and Digital Circuits and Systems", pages 276-278, especially page 277.

## Description

### Background Of The Invention

The present invention relates generally to the transfer of audio signals between electronic devices. More particularly, the invention relates to a line receiver circuit that reduces the amount of noise introduced into an audio signal as the signal is transferred between physically separated electronic devices.

An audio system typically includes a combination of electronic devices such as preamplifiers, mixers, power amplifiers, etc. In an audio system designed for a large listening audience such as in a convention hall, theater, or building, such electronic devices might be physically separated by large distances and powered by different ac power line circuits. The different ac power line circuits can introduce significant undesired noise to the audio signal.

Each ac power line circuit has its own local ground reference. The capacitance between the ac power line and the chassis of each electronic device can induce a voltage at the local ground of the chassis. Thus, a considerable voltage difference can arise between the local grounds of the various electronic devices of the audio system. This voltage difference causes a current to flow in any conductor that interconnects electronic devices connected to different ac power line circuits. These currents that flow through the conductor between the electronic devices are often rich in harmonics of the power line frequency, which is typically 50 to 60 hertz. These harmonics of the power line frequency are heard as a distracting hum or buzz, if reproduced by the audio system.

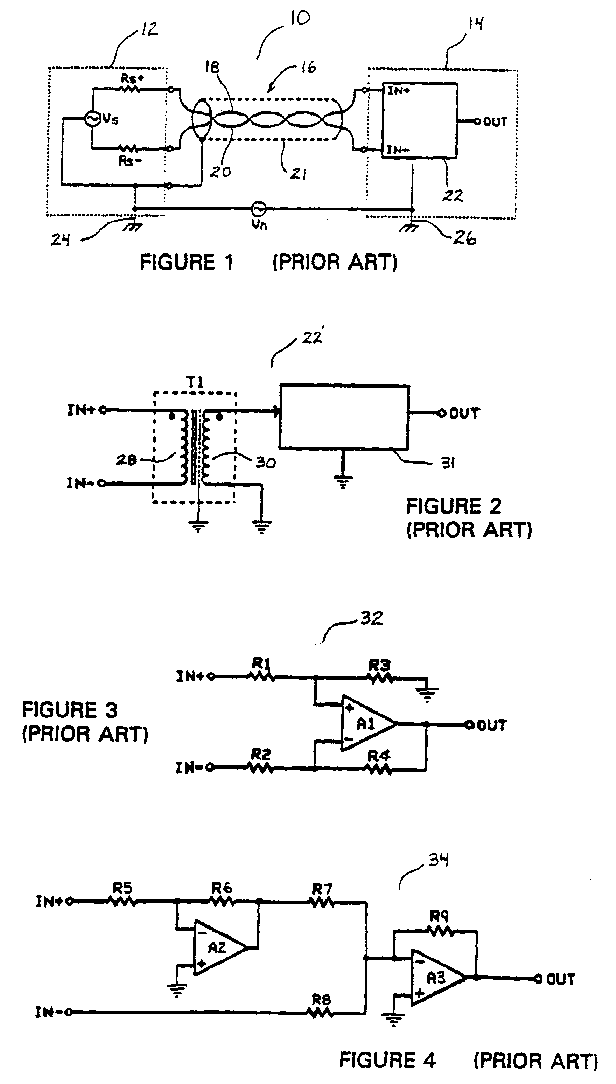

With reference to FIG. 1, a prior art audio system 10 is shown to include a driving device 12 and a receiving device 14. An audio signal Vs is transmitted from the driving device to the receiving device over a cable 16 that includes a conductor pair having first and second differential lines 18 and 20, respectively. The cable may also include a shield 21 that surrounds the first and second differential lines. Typically the shield is connected to the local ground 24 of the driving device. The audio signal Vs is transmitted in a differential mode, which means that the audio signal is represented by the difference in voltage between the differential lines 18 and 20 irrespective of any local ground reference. The driving device has a source impedance associated with its positive and negative output designated Rs+ and Rs-, respectively. The receiving device includes a line receiver 22 which has an input impedance associated with its positive and negative input terminals, designated IN+ and IN-, respectively.

The noise voltage Vn caused by the voltage difference between the local grounds 24 and 26 of the respective driving device 12 and receiving device 14 is presented simultaneously to both input terminals IN+ and IN- of the line receiver 22. This noise voltage Vn is commonly referred to as a common-mode voltage. A common-mode voltage is a voltage referenced to the local ground of the receiving device that is present at both input terminals IN+ and IN- of the line receiver 22. The common-mode noise voltage Vn contains the undesired harmonics of the power line frequency and it is very desirable for the receiving device to reject such common-mode voltage signals.

As shown in FIG. 2, one method for the line receiver 22' to reject the common-mode voltage signals is to use a transformer T1 coupled to the inputs of the receiving device 14. The common-mode noise voltage , which is applied simultaneously to both inputs IN+ and IN- of the primary winding 28, is not transmitted from the primary winding to the secondary winding 30 of the transformer, but the differential-mode audio signal is transmitted. Accordingly, the amplifier 31 receives only the differential-mode audio signal. Although the transformer therefore is effective in eliminating common-mode noise voltage, Vn, it has cost, size, and weight disadvantages that limit its widespread use.

With reference to FIG. 3, a simple voltage-mode differential amplifier circuit 32 has been used in the past as a line receiver that eliminates common-mode noise without using a transformer. The circuit 32 includes an operational amplifier A1 and four gain/bias resistors R1, R2, R3 and R4. The circuit 32 has two input terminals IN+ and IN- and an output terminal OUT. The voltage gain for voltage signals applied to the input terminal IN- is -R4/R2. The voltage gain for voltage signals applied to the input terminal IN+ is [(R2 + R4)/R2] [R3/(R1 + R3)]. By setting R1 equal to R2 and R3 equal to R4, the voltage gain for voltage signals applied to the input terminal IN+ becomes R4/R2. The voltage gain for common-mode voltage signals is found by summing the voltage gain of the two inputs together. Thus, the gain of the differential amplifier circuit 32 for common-mode voltage signals is zero, if resistors R1 and R3 are matched to resistors R2 and R4 respectively, since (R4/R2) + (-R4/R2) = 0. Thus, by carefully matching the resistor values, any common-mode voltages at the input terminals IN+ and IN- are substantially rejected.

In actual practice, the resistors R1 and R2 and the resistors R3 and R4 are never perfectly matched, and the rejection of common-mode voltage signals is quantified as the common-mode rejection ratio (CMRR). The CMRR of a differential amplifier circuit is defined as the gain of differential-mode signals divided by the gain of common-mode signals. In addition, the effects of the output impedances Rs+ and Rs- of the driving device 12 which have not yet been discussed, can adversely affect CMRR.

With reference now to FIG. 4, a simple current-mode differential amplifier circuit 34 also has been used in the past as a line receiver that eliminates common-mode noise without using a transformer. The circuit 34 includes two operational amplifiers A2 and A3, and five gain/bias resistors R5, R6, R7, R8 and R9. Like the voltage-mode circuit discussed above, this circuit has two input terminals IN+ and IN- and an output terminal OUT. The inverting terminal of the operational amplifier A3 acts as a current summing node at virtual ground. The current through the resistors R7 and R8 is determined by the classic ohm's law formula I = V/R. The current through the resistor R9 is merely the negative sum of the currents through the resistors R7 and R8. To have the amplifier operate in a differential mode, one input, in this case the input associated with the resistor R7, is inverted by the inverting amplifier configuration of the resistors R5 and R6 and the operational amplifier A2.

The resistor pair R5 and R6 and the resistor pair R7 and R8 should be matched to obtain a large CMRR. In actual practice, the resistor pair R5 and R6 and the resistor pair R7 and R8 are never perfectly matched, which results in a finite CMRR as discussed above with respect to the voltage-mode differential amplifier.

The differential amplifier circuits 32 and 34 shown in FIGS. 3 and 4 offer good common-mode voltage rejection only if the source impedances Rs+ and Rs- of the driving device 12 are very closely matched. If the source impedances are not closely matched, the circuit's CMRR degrades significantly. The CMRR degrades because these circuits have relatively low common-mode input impedances at their two input terminals IN+ and IN-. These low input impedances are in series with the source impedances. If the source impedances are not exactly equal, an unequal voltage division of the audio signal occurs at the input terminals IN+ and IN-. For example, in practical application of the circuits 32 and 34 shown in FIGS. 3 and 4, a source impedance imbalance of only 5 ohms will degrade the CMRR from 80 db to 40 db.

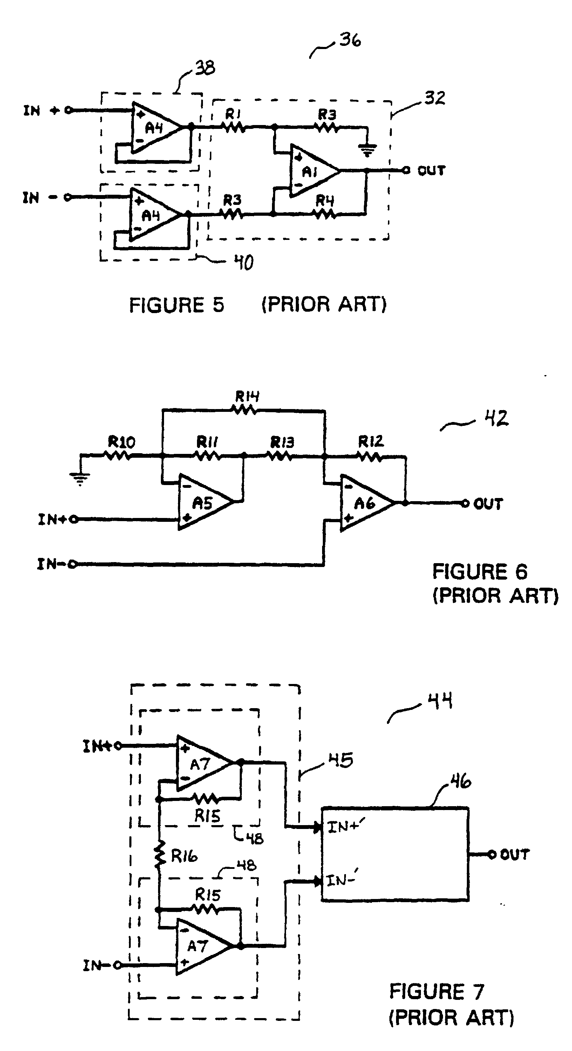

With reference now to FIG. 5, a more complex instrumentation amplifier circuit 36 can substantially eliminate the sensitivity of the simple differential amplifier circuits 32 and 34 to unbalanced source impedances of the driving device 12. The instrumentation amplifier circuit 36 has two input buffers 38 and 40 connected to the respective inputs of the differential amplifier, shown here as a voltage-mode differential amplifier 32. Each input buffer is typically an operational amplifier A4 configured for unity gain. The large input impedance of the operational amplifier reduces to negligible levels the voltage division effects caused by the source impedance. The output impedance of the operational amplifier is very small and does not vary significantly over a large range of output current levels. Thus, the input buffers 38 and 40 prevent the unbalanced source impedances of a driving device from reducing the CMRR of the differential amplifiers 32 and 34.

An instrumentation amplifier 42 shown in FIG. 6, is known to eliminate common-mode noise. The amplifier includes two operational amplifiers A5 and A6 and five gain/bias resistors R10, R11, R12, R13 and R14. By matching the gain/bias resistors, the circuit exhibits unity gain for differential-mode signals and zero gain for common-mode signals. However, as mentioned above, the gain/bias resistors are never perfectly matched and the amplifier exhibits a finite CMRR.

An improved instrumentation amplifier 44, shown in FIG. 7, also is known to improve the performance of a simple differential amplifier 46, such as the differential amplifiers 32 and 34 shown in FIGS. 3 and 4, respectively. The instrumentation amplifier has a differential-gain stage 45 between the input terminals IN+ and IN- of the instrumentation amplifier and the input terminals IN+' and IN-' of the differential amplifier 46. The differential-gain stage includes two identical circuits 48, each circuit including an operational amplifier A7 and a bias/gain resistor R15, and each connected to a separate input terminal. The noninverting input of one operational amplifier A7 is connected to the input terminal IN+, and the noninverting input of the other operational amplifier A7 is connected to the input terminal IN-. A resistor R15 is connected between the inverting input and the output of each amplifier A7, and a resistor R16 is connected between the inverting inputs of the two operational amplifiers. The outputs of the two operational amplifiers A7 are connected to the respective inputs IN+' and IN-' of the differential amplifier 46. The differential amplifier 46 may take the form of either the voltage-mode differential amplifier 32 shown in FIG. 3 or the current-mode differential amplifier 34 shown in FIG. 4.

The differential-gain stage amplifies differential mode signals by a factor equal to (2R15 + R16)/R16 and amplifies common-mode signals by unity. Thus, the differential amplifier 46 receives a signal in which the common-mode signal has already been suppressed by a factor of (2R15 + R16)/R16, thereby improving the CMRR of the instrumentation amplifier 44 over that of the simple differential amplifier.

However, each of the instrumentation amplifier circuits 36, 42 and 44 shown in FIGS. 5, 6 and 7, respectively, has a serious practical problem when used as a line receiver in an audio system, because the inputs of the operational amplifiers may have no external dc paths for their bias currents. Such dc bias currents are necessary for the operational amplifiers to function properly. Since the signal sources of an audio system are often ac coupled, they cannot be relied upon to provide the dc path. In addition, using a resistor connected to a local ground terminal to provide the dc path will degrade the CMRR of these instrument amplifier circuits by lowering the input impedance of each input buffer.

It should therefore be appreciated that there is the need for amplifier circuits that, when used as a differential audio line receiver, provide a very large common-mode input impedance while at the same time providing a de path for the bias currents of the operational amplifiers. The present invention fulfils this needs.

### Summary of the Invention

According to the present invention there is provided an audio line receiver for receiving a differential-mode input signal from first and second differential lines and for outputting an output signal relative to a local ground reference on an output line, the audio line receiver comprising: a differential amplifier having first and second input terminals and an output terminal, wherein the output terminal of the differential amplifier is connected to the output line; and a gain-stage amplifier having first and second differential input terminals and first and second differential output terminals, the first differential output terminal being coupled to the first input terminal of the differential amplifier and the second differential output terminal being coupled to the second input terminal of the differential amplifier; characterized in that the first differential input terminal is dc connected to the first differential line and the second differential input terminal is dc connected to the second differential line, in that the gain-stage amplifier provides at each input terminal, a dc current path to a ground terminal sufficient to accommodate a bias current and from each output thereof a common-mode ac feedback path through part of said dc current path to ground, said ac feedback path providing high input impedance to common mode ac signals above a predetermined frequency, such that the common mode input impedances of the line receiver is effectively larger for common mode ac signals above the predetermined frequency than for common mode dc signals; whereby, above the predetermined frequency, the line receiver receives the differential-mode input signal and substantially rejects any common-mode signals received along with the differential-mode input signal;
wherein the gain-stage amplifier comprises: first and second operational amplifiers each having an output terminal, an inverting input terminal, and a noninverting input terminal, the noninverting input terminal of the first operation amplifier being connected to the first differential input terminal, the noninverting input terminal of the second operation amplifier being connected to the second differential input terminal, the output terminal of the first operational amplifier being connected to the first differential output terminal, and the output terminal of the second operations amplifier being connected to the second differential output terminal; first, second and third gain resistors, the first gain resistor being connected between the output and the inverting input of the first operational amplifier, the second gain resistor being connected between the output and the inverting input of the second operational amplifier, and the third gain resistor being connected between the inverting inputs of the first and second operational amplifiers; first and second bias resistors connected in series between the first and second differential input terminals; a third bias resistor connected between the ground terminal and the node between the first and second bias resistors to provide the dc current path from the first and second differential input terminals to the ground terminal; fourth and fifth bias resistors connected in series between the first and second differential output terminals; a unity-gain amplifier having an input terminal and an output terminal, the input terminal of the unity-gain amplifier being connected to a node between the fourth and fifth bias resistors; and a capacitor connected between the output terminal of the unity-gain amplifier and the node between the first, second and third bias resistors, the capacitor being sized to have an impedance less than the resistance of the third bias resistor at frequencies above the predetermined frequency.

In a second aspect, the invention provides an audio line receiver for receiving a differential-mode input signal from first and second differential lines and for outputting an output signal relative to a local ground reference on an output line, the audio line receiver comprising: a differential amplifier having first and second input terminals and an output terminal, wherein the output terminal of the differential amplifier is connected to the output line; and a gain-stage amplifier having first and second differential input terminals and first and second differential output terminals, the first differential output terminal being coupled to the first input terminal of the differential amplifier and the second differential output terminal being coupled to the second input terminal of the differential amplifier; characterized in that the first differential input terminal is dc connected to the first differential line and the second differential input terminal is dc connected to the second differential line, in that the gain-stage amplifier provides at each input terminal, a dc current path to a ground terminal sufficient to accommodate a bias current and from each output thereof a common-mode ac feedback path through part of said dc current path to ground, said ac feedback path providing high input impedance to common mode ac signals above a predetermined frequency, such that the common mode input impedances of the line receiver is effectively larger for common mode ac signals above the predetermined frequency than for common mode dc signals; whereby, above the predetermined frequency, the line receiver receives the differential-mode input signal and substantially rejects any common-mode signals received along with the differential-mode input signal; wherein the gain-stage amplifier comprises: first and second unity-gain amplifiers, each having an input terminal and an output terminal, the input terminals of the first and second unity-gain amplifiers being directly connected to the first and second input terminals, respectively, of the gain-stage amplifier, and the output terminals of the first and second unity-gain amplifiers being directly connected to the first and second output terminals, respectively, of the gain-stage amplifier; first and second bias resistors directly connected in series between the first input terminal of the gain-stage amplifier and a ground terminal for providing a dc current path from the first input terminal to the ground terminal; third and fourth bias resistors directly connected in series between the second input terminal of the gain-stage amplifier and the ground terminal for providing a dc current path from the second input terminal to the ground terminal; and a first capacitor coupled between the first output terminal of the gain-stage amplifier and a node between the first and second bias resistors and a second capacitor coupled between the second output terminal of the gain-stage amplifier and a node between the third and fourth bias resistors.

A typical line frequency is 60 Hz, which is higher than the lowest audible frequency of the audio signal. The predetermined frequency is chosen such that all the differential mode audio signals frequencies are received while the common-mode line frequencies and harmonics are substantially rejected.

The predetermined frequency may be chosen to be about 0.1 Hz. Such a frequency can be achieved by sizing first and second bias resistors to have resistance of about 25 kilohms and by sizing a capacitor to have a capacitance of about 65 microfarads. Another desired embodiment of the invention achieves a similar performance by sizing first and second bias resistors to have a resistance of about 10 kilohms and by sizing a capacitor having a capacitance of about 100 microfarads.

In a more detailed feature of the invention, a power supply is connected between the third bias resistor and the ground terminal. The power supply provides electrical power at the first and second differential input through the first, second and third bias resistors. This electrical power can be used to power a device (for example, a professional microphone) coupled to the first and second differential input terminals.

In yet another more detailed feature of the invention, the unity-gain amplifier is an operational amplifier configured for unity gain by having its inverting input terminal directly connected to its output terminal. A signal at the noninverting input terminal of the unity-gain amplifier is amplified by unity-gain and provided at the output terminal.

Other features and advantages of the present invention should become apparent from the following description of the preferred embodiment, taken in conjunction with the accompanying drawings, which illustrate, by way of example, the principles of the invention.

### Brief Description Of The Drawings

FIG. 1 is a schematic diagram of an audio system having physically separated electronic devices.
FIG. 2 is a schematic diagram of a transformer coupled differential receiver of the prior art.
FIG. 3 is a schematic diagram of a simple voltage-mode differential amplifier of the prior art.
FIG. 4 is a schematic diagram of a simple current-mode differential amplifier of the prior art.
FIG. 5 is a schematic diagram of a prior art differential amplifier having buffered inputs.
FIG. 6 is a schematic diagram of a simple current-mode differential amplifier of the prior art.
FIG. 7 is a schematic diagram of a prior art instrumental amplifier.
FIG. 8 is a schematic diagram of an audio line receiver embodying the present invention.
FIG. 9 is a schematic diagram of a more general embodiment of the audio line receiver shown in FIG. 8.
FIG. 10 is a schematic diagram of an instrumentation amplifier embodying the present invention.
FIG. 11 is a schematic diagram of a portion of the instrumentation amplifier shown in FIG. 10, additionally including a "phantom" power supply.

### Description Of The Preferred Embodiments

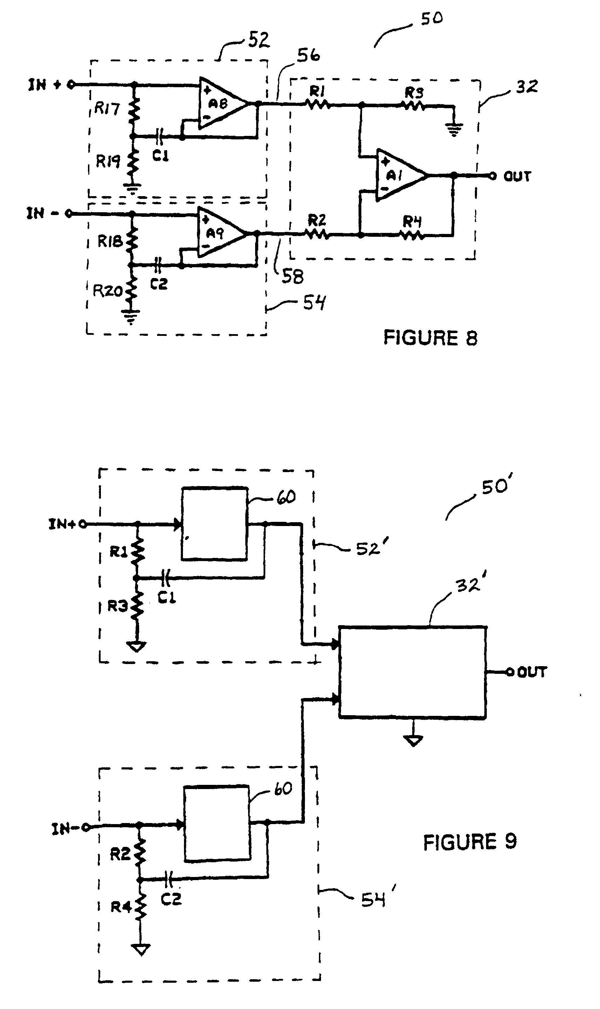

FIG. 8 shows a first embodiment of the differential audio line receiver 50 in accordance with the present invention, for receiving audio signals from a driving device 12. The line receiver includes a differential amplifier 32 and two input amplifiers 52 and 54. The differential amplifier 32, which combines an operational amplifier A1 and resistors R1, R2, R3 and R4, corresponds to the prior art differential amplifier 32 of FIG. 2. The differential amplifier includes a noninverting input terminal 56, an inverting input terminal 58, and an output terminal OUT, and it operates in the manner described above in the Background of the Invention above. The preferred resistance value for resistors R1, R2, R3 and R4 is 25KΩ.

The input amplifiers 52 and 54 each have an input terminal IN+ and IN-, respectively, and each have an output terminal. The output terminal of the first input amplifier 52 is connected to the noninverting input terminal 56 of the differential amplifier 32, and the output terminal of the second input amplifier 54 is connected to the inverting input terminal 58 of the differential amplifier 32.

The first input amplifier 52 includes an operational amplifier A8, two biasing resistors R17 and R19 and a coupling capacitor C1. The bias resistors R17 and R19 are connected in series between the noninverting input terminal of the operational amplifier A8 and a signal ground terminal. The noninverting input terminal of the operational amplifier A8 serves as the input terminal IN+ of the input amplifier 52. The inverting input terminal of the operational amplifier A8 is connected directly to the output terminal of the operational amplifier A8. Thus, the bias resistors R17 and R19 provide a dc current path to ground for the noninverting input of the operational amplifier A8. The coupling capacitor C1 prevents the bias resistors R17 and R19 from lowering the input impedance of the input amplifier 52, which would reduce the common-mode rejection ratio (CMRR) of the line receiver 50.

By connecting the coupling capacitor C1 from the inverting input terminal of the operational amplifier A8 to the node between resistors R17 and R19, the resistor R17 can be made effectively to have a very large impedance at frequencies above a predetermined cutoff frequency. The predetermined cutoff frequency is the frequency at which the impedance of coupling capacitor C1 is equal to the resistance of the resistor R19. At frequencies substantially above this cutoff frequency, the node between resistors R17 and R19 is thereby effectively shorted to the inverting input terminal of the operational amplifier A81. The operational amplifier A8 causes the same voltage to appear at both ends of the resistor R17, so that substantially no ac current flows through the resistor R17 at such frequencies. Accordingly, the substantially reduced current flow through the resistor R17 causes the effective resistance of the resistor R17 to be much larger than its actual or dc value. Thus, the input amplifier 52 provides a very high effective input impedance at frequencies substantially above the predetermined cutoff frequency.

In a similar manner, the second input amplifier 54 includes an operational amplifier A9, bias resistors R18 and R20, and a coupling capacitor C2 that effectively isolates the inverting input terminal 58 of the differential amplifier 32.

The cutoff frequency must be low enough so that the common-mode input impedance of line receiver 50 is sufficiently high over all frequencies of interest for rejection of undesired common-mode noise. Such a line receiver 50 having a sufficiently low cut-off frequency will exhibit a gain that is sufficiently constant over all frequencies of interest in the audio signal. However, the cutoff frequency must be large enough to be readily implemented using standard available components. To eliminate low-frequency common-mode noise voltages including the power line frequency of 50 or 60 Hz, and harmonics of that frequency, the cutoff frequency defined by the combination of the capacitor C1 and the resistor R19 and of the combination of the capacitor C2 and the resistor R20, at the input amplifiers 52 and 54 preferably is selected to be about .1 Hz. Such a cutoff frequency can be achieved using resistance values for the resistors R17, R18, R19 and R20 of about 25 kilohms and capacitance values for the capacitors C1 and C2 of about 65 microfarads. A desirable cutoff frequency of .16 Hz is achieved using resistance values for R17, R18, R19 and R20 of about 10 kilohms and capacitance values for the capacitors C1 and C2 of about 100 microfarads.

The output impedance of each of the input amplifiers 52 and"54 is substantially uniform over a wide range of signal levels. The high effective input impedance and the low output impedance of the input amplifiers 52 and 54 reduces the voltage division effects caused by imbalances between the sources impedances Rs+ and Rs- and effectively isolates or buffers the inputs of the differential amplifier 32 from the source impedances Rs+ and Rs- of the driving device 12. Thus, the line receiver 50 can receive audio signals from a wide variety of electronic audio equipment having any combination of ac- or dc-coupled outputs and wide range of balanced or unbalanced source impedances with a minimal deterioration of the rejection of common-mode voltage signals.

The line receiver 50 of the present invention is more general than the specific embodiment shown in FIG. 8. Another embodiment of the line receiver 50', shown in FIG. 9, indicates that the differential amplifier 32 of FIG. 8 may be replaced with many types of differential amplifiers 32', such as the simple differential amplifier 34 or the instrumentation amplifier 44 discussed above. Also, the input amplifiers 52 and 54 of FIG. 8 need not be limited to the unity-gain operational amplifiers A8 and A9. Instead, the unity-gain operational amplifiers may be replaced with most any type of unity-gain amplifier 60 as shown in FIG. 9. Each unity gain amplifier 60 need only have the characteristics of approximately unity-gain, a relatively high input impedance, and a relatively low output impedance. Accordingly, each unity-gain amplifier 60 may be constructed using a combination of operational amplifiers, discrete semiconductors, vacuum tubes, etc.

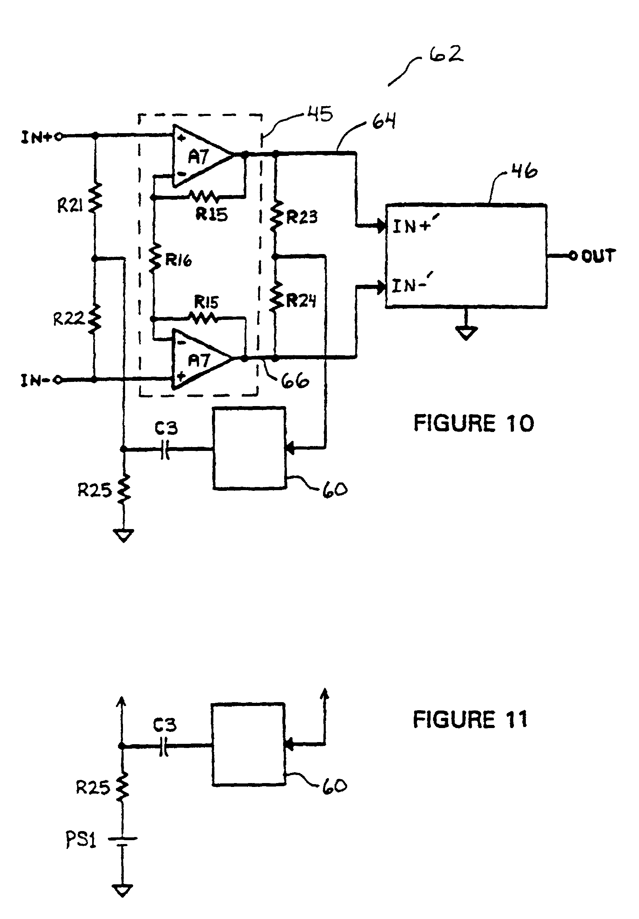

An alternative embodiment of the present invention is the instrumentation amplifier 62 shown in FIG. 10. This instrumentation amplifier is a modification to the instrumentation amplifier 44 of FIG. 7. In the instrumentation amplifier of the present invention, two resistors R21 and R22 are connected in series between the input terminals IN+ and IN- and two resistors R23 and R24 are connected in series between the output terminals 64 and 66 of the differential-gain stage 45. A resistor 25 is connected between a ground terminal and the node between the two resistors R23 and R24 to provide a dc bias current path for the inputs IN+ and IN-,

A unity-gain amplifier 60 and a capacitor C3, connected in series with the unity-gain amplifier, are connected between the node between the resistors R23 and R24 and the node between the resistors R21, R22 and R25. As mentioned before, the common-mode gain of the differential-gain stage 45 is essentially unity while the differential-mode gain of the differential-gain stage is very high. The common-mode output of the differential gain stage is coupled through the resistors R23 and R24, to the unity gain amplifier 60. Through the capacitor C3, the unity-gain amplifier, drives the node between the resistors R21, R22, and R25 with the buffered common-mode signal which causes both resistors R21 and R22 to exhibit a high ac impedance to common-mode signals, while also providing a dc bias path through resistor R25. Note that the embodiment of the instrumentation amplifier 62 shown in FIG. 10 requires only one unity-gain amplifier.

As shown In FIG. 11, the instrumentation amplifier 62 of FIG. 10 is readily suitable as a low signal-level preamplifier modified for use with a professional microphone, such as those for low impedance microphones, which typically is powered by a "phantom" power supply. A "phantom" power supply is provided to a microphone connected to the inputs IN+ and IN- of the instrumentation amplifier by connecting the resistor R25 to the "phantom" power supply PS1 instead of to a ground terminal. The resistors R21, R22 and R25 will provide a current path for the required power supply and dc bias currents, while exhibiting a very high impedance at audio frequencies. Accordingly, the instrumentation amplifier will eliminate source impedance effects that can degrade the CMRR of the amplifier at audio frequencies.

Although the foregoing discloses preferred embodiments of the present invention, it is understood that those skilled in the art may make various changes to the preferred embodiments shown without departing from the scope of the invention. The invention is defined only by the following claims.

## Claims

1. An audio line receiver (62) for receiving a differential-mode input signal from first and second differential lines and for outputting an output signal relative to a local ground reference on an output line, the audio line receiver comprising:
a differential amplifier (46) having first and second input terminals (64, 66) and an output terminal (OUT), wherein the output terminal of the differential amplifier (46) is connected to the output line; and
a gain-stage amplifier (45) having first and second differential input terminals (IN+, IN-) and first and second differential output terminals, the first differential output terminal being coupled to the first input terminal (64) of the differential amplifier (46) and the second differential output terminal being coupled to the second input terminal (66) of the differential amplifier; **characterized in that**
the first differential input terminal (IN+) is dc connected to the first differential line and the second differential input terminal (IN-) is dc connected to the second differential line, **in that** the gain-stage amplifier (45) provides at each input terminal (IN+, IN-), a dc current path to a ground terminal sufficient to accommodate a bias current and from each output thereof a common-mode ac feedback path through part of said dc current path to ground, said ac feedback path providing high input impedance to common mode ac signals above a predetermined frequency, such that the common mode input impedances of the line receiver is effectively larger for common mode ac signals above the predetermined frequency than for common mode dc signals; whereby, above the predetermined frequency, the line receiver receives the differential-mode input signal and substantially rejects any common-mode signals received along with the differential-mode input signal;
wherein the gain-stage amplifier (45) comprises:
first and second operational amplifiers (A7;A7) each having an output terminal, an inverting input terminal, and a noninverting input terminal, the noninverting input terminal of the first operation amplifier (A7) being connected to the first differential input terminal, the noninverting input terminal of the second operation amplifier (A7) being connected to the second differential input terminal, the output terminal of the first operational amplifier (A7) being connected to the first differential output terminal, and the output terminal of the second operations amplifier (A7) being connected to the second differential output terminal;
first, second and third gain resistors (R15,R16,R15), the first gain resistor (R15) being connected between the output and the inverting input of the first operational amplifier (A7), the second gain resistor (R15) being connected between the output and the inverting input of the second operational amplifier (A7), and the third gain resistor (R16) being connected between the inverting inputs of the first and second operational amplifiers (A7;A7);
first and second bias resistors (R21,R22) connected in series between the first and second differential input terminals;
a third bias resistor (R25) connected between the ground terminal and the node between the first and second bias resistors (R21,R22) to provide the dc current path from the first and second differential input terminals to the ground terminal; fourth and fifth bias resistors (R23,R24) connected in series between the first and second differential output terminals;
a unity-gain amplifier (60) having an input terminal and an output terminal, the input terminal of the unity-gain amplifier (60) being connected to a node between the fourth and fifth bias resistors (R23,R24); and
a capacitor (C3) connected between the output terminal of the unity-gain amplifier (60) and the node between the first, second and third bias resistors (R21,R22,R25), the capacitor being sized to have an impedance less than the resistance of the third bias resistor (R25) at frequencies above the predetermined frequency.

2. An audio line receiver (50) for receiving a differential-mode input signal from first and second differential lines and for outputting an output signal relative to a local ground reference on an output line, the audio line receiver comprising:
a differential amplifier (32) having first and second input terminals (56,58) and an output terminal (OUT), wherein the output terminal of the differential amplifier (32) is connected to the output line; and
a gain-stage amplifier (52,54) having first and second differential input terminals (IN+, IN-) and first and second differential output terminals, the first differential output terminal being coupled to the first input terminal (56) of the differential amplifier (32) and the second differential output terminal being coupled to the second input terminal (58) of the differential amplifier; **characterized in that**
the first differential input terminal (IN+) is dc connected to the first differential line and the second differential input terminal (IN-) is dc connected to the second differential line, **in that** the gain-stage amplifier (52,54) provides at each input terminal (IN+, IN-), a dc current path to a ground terminal sufficient to accommodate a bias current and from each output thereof a common-mode ac feedback path through part of said dc current path to ground, said ac feedback path providing high input impedance to common mode ac signals above a predetermined frequency, such that the common mode input impedances of the line receiver is effectively larger for common mode ac signals above the predetermined frequency than for common mode dc signals; whereby, above the predetermined frequency, the line receiver receives the differential-mode input signal and substantially rejects any common-mode signals received along with the differential-mode input signal;
wherein the gain-stage amplifier comprises:
first and second unity-gain amplifiers (A8, A9), each having an input terminal and an output terminal, the input terminals of the first and second unity-gain amplifiers being directly connected to the first and second input terminals, respectively, of the gain-stage amplifier, and the output terminals of the first and second unity-gain amplifiers being directly connected to the first and second output terminals, respectively, of the gain-stage amplifier;
first and second bias resistors (R1,R3) directly connected in series between the first input terminal of the gain-stage amplifier and a ground terminal for providing a dc current path from the first input terminal to the ground terminal;
third and fourth bias resistors (R2,R4) directly connected in series between the second input terminal of the gain-stage amplifier and the ground terminal for providing a dc current path from the second input terminal to the ground terminal; and
a first capacitor (C1) coupled between the first output terminal of the gain-stage amplifier and a node between the first and second bias resistors (R1,R3) and a second capacitor (C2) coupled between the second output terminal of the gain-stage amplifier and a node between the third and fourth bias resistors (R2,R4).

3. An audio line receiver as defined in Claim 1 or Claim 2, **characterized in that** the gain-stage amplifier further provides dc electrical power at its first and second differential input terminals.

4. An audio line receiver as defined in Claim 1, **characterized in that** the gain-stage amplifier comprises:
a dc power source (PSI) connected to the ground terminal;
wherein the third bias resistor (R25) is connected in series with the dc power source (PSI), between the ground terminal and a node between the first and second bias resistors (R21,R22), to provide the dc current path from the first and second differential input terminals to the ground terminal through the dc power source and to provide dc electrical power at the first and second differential input terminals.

5. An audio line receiver as defined in Claim 1, **characterized in that** the first, second and the third bias resistors (R21,R22,R25) each have a resistance of about 10 kilohms, and the capacitor (6) has a capacitance in the order of 100 microfarads.

6. An audio line receiver as defined in Claim 1, **characterized in that** the unity-gain amplifier (60) comprises:
a third operational amplifier having an inverting input terminal, a noninverting input terminal, and an output terminal, wherein the noninverting input terminal of the third operational amplifier is connected to the input terminal of the unity-gain amplifier and
wherein the output terminal of the third operational amplifiers is connected to the inverting input terminal of the third operational amplifier and to the output terminal of the unity-gain amplifier.

7. An audio line receiver as defined in Claim 2, wherein the first capacitor (C1) is sized to cause the audio line receiver to have an input impedance greater than the resistance of the first and second bias resistors (R1,R3) at frequencies above a predetermined frequency, and the second capacitor (C2) is sized to cause the audio line receiver have an input impedance greater than the resistance of the third and fourth bias resistors (R2,R4) at frequencies above a predetermined frequency.

8. An audio line receiver as defined in Claim 2, **characterized in that** the first bias resistor (R1; R3) has a resistance of about 25 kilohms, the second bias resistor (R2; R4) has a resistance of about 25 kilohms, and the capacitor (C1; C2) has a capacitance of about 65 microfarad.

9. An audio line receiver as defined in Claims 1 or Claim 2, **characterized in that** the common-mode signals substantially rejected by the line receiver are harmonics of a power line frequency of substantially 60 hertz.

## Patentansprüche

1. Niederfrequenz-Leitungsempfänger (62) zum Empfangen eines Differenzeingangssignals ab ersten und zweiten Differenzleitungen und zur Ausgabe eines Ausgangssignals relativ zu einer lokalen Bodenreferenz auf einer Ausgangsleitung, wobei der Niederfrequenz-Leitungsempfänger umfasst:
einen Differenzverstärker (46) mit ersten und zweiten Eingangsklemmen (64,66) und einer Ausgangsklemme (OUT), wobei die Ausgangsklemme des Differenzverstärkers (46) mit der Ausgangsleitung verbunden ist; und
einen Verstärkungsstufen-Verstärker (45) mit ersten und zweiten Differenzeingangsklemmen (IN+,IN-) und ersten und zweiten Differenzausgangsklemmen, wobei die erste Differenzausgangsklemme an die erste Eingangsklemme (64) des Differenzverstärkers (46) gekoppelt ist und die zweite Differenzausgangsklemme an die zweite Eingangsklemme (66) des Differenzverstärkers gekoppelt ist, **dadurch gekennzeichnet, dass**
die erste Differenzeingangsklemme (IN+) Gleichstromanschluss an die erste Differenzleitung aufweist und die zweite Differenzeingangsklemme (IN-) Gleichstromanschluss an die zweite Differenzleitung aufweist, indem der Verstärkungsstufen-Verstärker (45) an jeder Eingangsklemme (IN+,IN-) einen Gleichstrom-Strompfad zu einer Erdklemme, der ausreicht einen Vorspannungsstrom aufzunehmen und ab jedem Ausgang davon einen Gleichtakt-Wechselstromrückkopplungspfad durch einen Teil des besagten Gleichstrom-Strompfads zur Erde bereitstellt, wobei besagter Wechselstrom-Rückkopplungspfad hohe Eingangsimpedanz zu Gleichtakt-Wechselstromsignalen oberhalb einer vorbestimmten Frequenz bereitstellt, dermaßen, dass die Gleichtakt-Eingangsimpedanzen des Leitungsempfängers für Gleichtakt-Wechselstromsignale oberhalb der vorbestimmten Frequenz effektiv größer als für Gleichtakt-Gleichstromsignale ist; wodurch, oberhalb der vorbestimmten Frequenz, der Leitungsempfänger das Differenzeingangssignal empfängt und im wesentlichen jedwede zusammen mit dem Differenzeingangssignal empfangenen Gleichtaktsignale zurückweist;
wobei der Verstärkungstufen-Verstärker (45) umfasst:
erste und zweite Operationsverstärker (A7,A7), wobei jeder eine Ausgangsklemme, eine invertierende Eingangsklemme und eine nichtinvertierende Eingangsklemme aufweist, wobei die nicht invertierende Eingangsklemme des ersten Operationsverstärkers (A7) an die erste Differenzeingangsklemme angeschlossen ist, die nichtinvertierende Eingangsklemme des zweiten Operationsverstärkers (A7) an die zweite Differenzeingangsklemme angeschlossen ist, die Ausgangsklemme des ersten Operationsverstärkers (A7) an die erste Differenzausgangsklemme angeschlossen ist und die Ausgangsklemme des zweiten Operationsverstärkers (A7) an die zweite Differenzausgangsklemme angeschlossen ist;
erste, zweite und dritte Verstärkungswiderstände (R15,R16,R15), wobei der erste Verstärkungswiderstand (R15) zwischen dem Ausgang und dem invertierenden Eingang des ersten Operationsverstärkers (A7) angeschlossen ist, der zweite Verstärkungswiderstand (R15) zwischen dem Ausgang und dem invertierenden Eingang des zweiten Operationsverstärkers (A7) angeschlossen ist und der dritte Verstärkungswiderstand (R16) zwischen den invertierenden Eingängen des ersten und zweiten Operationsverstärkers (A7;A7) angeschlossen ist;
erste und zweite in Reihe zwischen den ersten und zweiten Differenzeingangsklemmen angeschlossene Vorspannungswiderstände (R21,R22);
einen dritten Vorspannungswiderstand (R25), der zwischen der Erdklemme und dem Knoten zwischen den ersten und zweiten Vorspannungswiderständen (R21,R22) angeschlossen ist, um den Gleichstrom-Strompfad ab den ersten und zweiten Differenzeingangsklemmen zur Erdklemme bereitzustellen; vierte und fünfte Vorspannungswiderstände (R23,R24) sind in Reihe zwischen den ersten und zweiten Differenzausgangsklemmen angeschlossen;
einen Verstärker (60) mit dem Verstärkungsfaktor 1 mit einer Eingangklemme und einer Ausgangsklemme, wobei die Eingangsklemme des Verstärkers (60) mit dem Verstärkungsfaktor 1 (60) an einen Knoten zwischen den vierten und fünften Vorspannungswiderständen (R23,R24) angeschlossen ist; und
einen Kondensator (C3), der zwischen der Ausgangsklemme des Verstärkers (60) mit dem Verstärkungsfaktor 1 und dem Knoten zwischen den ersten, zweiten und dritten Vorspannungswiderständen (R21,R22,R25) angeschlossen ist, wobei der Kondensator so bemessen wird, dass er eine Impedanz aufweist, die geringer als der Widerstand des dritten Vorspannungswiderstands (R25) bei Frequenzen oberhalb der vorbestimmten Frequenz ist.

2. Niederfrequenz-Leitungsempfänger (50) zum Empfangen eines Differenzeingangssignals ab ersten und zweiten Differenzleitungen und zur Ausgabe eines Ausgangssignals relativ zu einer lokalen Bodenreferenz an einer Ausgangsleitung, wobei der Niederfrequenz-Leitungsempfänger umfasst:
einen Differenzverstärker (32) mit ersten und zweiten Eingangsklemmen (56,58) und einer Ausgangsklemme (OUT), wobei die Ausgangsklemme des Differenzverstärkers (32) mit der Ausgangsleitung verbunden ist; und
einen Verstärkungsstufen-Verstärker (52,54) mit ersten und zweiten Differenzeingangsklemmen (IN+,IN-) und ersten und zweiten Differenzausgangsklemmen, wobei die erste Differenzausgangsklemme an die erste Eingangsklemme (56) des Differenzverstärkers (32) gekoppelt ist und die zweite Differenzausgangsklemme an die zweite Eingangsklemme (58) des Differenzverstärkers gekoppelt ist, **dadurch gekennzeichnet, dass**
die erste Differenzeingangsklemme (IN+) Gleichstromanschluss an die erste Differenzleitung aufweist und die zweite Differenzeingangsklemme (IN-) Gleichstromanschluss an die zweite Differenzleitung aufweist, indem der Verstärkungsstufen-Verstärker (52,54) an jeder Eingangsklemme (IN+,IN-) einen Gleichstrom-Strompfad zu einer Erdklemme, der ausreicht einen Vorspannungsstrom aufzunehmen und ab jedem Ausgang davon einen Gleichtakt-Wechselstromrückkopplungspfad durch einen Teil des besagten Gleichstrom-Strompfads zur Erde bereitstellt, wobei besagter Wechselstrom-Rückkopplungspfad hohe Eingangsimpedanz zu Gleichtakt-Wechselstromsignalen oberhalb einer vorbestimmten Frequenz bereitstellt, dermaßen, dass die Gleichtakt-Eingangsimpedanzen des Leitungsempfängers für Gleichtakt-Wechselstromsignale oberhalb der vorbestimmten Frequenz effektiv größer als für Gleichtakt-Gleichstromsignale ist; wodurch, oberhalb der vorbestimmten Frequenz, der Leitungsempfänger das Differenzeingangssignal empfängt und im wesentlichen jedwede zusammen mit dem Differenzeingangssignal empfangenen Gleichtaktsignale zurückweist;
wobei der Verstärkungstufen-Verstärker umfasst:
erste und zweite Verstärker mit dem Verstärkungsfaktor 1 (A8,A9) mit je einer Eingangklemme und einer Ausgangsklemme, wobei die Eingangsklemmen der ersten und zweiten Verstärker mit dem Verstärkungsfaktor 1 direkt an die ersten bzw. zweiten Eingangsklemmen des Verstärkungsstufen-Verstärkers angeschlossen sind, und die Ausgangsklemmen der ersten und zweiten Verstärker mit dem Verstärkungsfaktor 1 direkt an die ersten bzw. zweiten Ausgangsklemmen des Verstärkungsstufen-Verstärkers angeschlossen sind;
erste und zweite Vorspannungswiderstände (R1,R3), die direkt in Reihe zwischen der ersten Eingangsklemme des Verstärkungsstufen-Verstärkers und einer Erdklemme angeschlossen sind, um einen Gleichstrom-Strompfad ab der ersten Eingangsklemme zur Erdklemme bereitzustellen;
dritte und vierte Vorspannungswiderstände (R2,R4), die direkt in Reihe zwischen der zweiten Eingangsklemme des Verstärkungsstufen-Verstärkers und der Erdklemme angeschlossen sind, um einen Gleichstrom-Strornpfad ab der zweiten Eingangsklemme zur Erdklemme bereitzustellen; und
einen ersten Kondensator (C1), der zwischen der ersten Ausgangsklemme des Verstärkungsstufen-Verstärkers und einem Knoten zwischen den ersten und zweiten Vorspannungswiderständen (R1,R3) angeschlossen ist, und einen zweiten Kondensator, der zwischen der zweiten Ausgangsklemme des Verstärkungsstufen-Verstärkers und einem Knoten zwischen den dritten und vierten Vorspannungswiderständen /R2,R4) angeschlossen ist.

3. Niederfrequenz-Leitungsempfänger wie in Anspruch 1 oder Anspruch 2 definiert, **dadurch gekennzeichnet, dass** der Verstärkungsstufen-Verstärker weiter Gleichstromleistung an seinen ersten und zweiten Differenzeingangsklemmen bereitstellt.

4. Niederfrequenz-Leitungsempfänger wie in Anspruch 1 definiert, **dadurch gekennzeichnet, dass** der Verstärkungsstufen-Verstärker umfasst:
eine Gleichstrom-Leistungsquelle (PSI), die an die Erdklemme angeschlossen ist;
wobei der dritte Vorspannungswiderstand (R25) in Reihe an die Gleichstrom-Leistungsquelle (PSI) zwischen der Erdklemme und einem Knoten zwischen den ersten und zweiten Vorspannungswiderständen (R21,R22) angeschlossen ist, um den Gleichstrom-Strompfad ab den ersten und zweiten Differenzeingangsklemmen durch die Gleichstrom-Leistungsquelle bereitzustellen und, um die Gleichstrom-Leistungsquelle an den ersten und zweiten Differenzeingangsklemmen bereitzustellen.

5. Niederfrequenz-Leitungsempfänger wie in Anspruch 1 definiert, **dadurch gekennzeichnet, dass** die ersten, zweiten und dritten Vorspannungswiderstände (R21,R22,R25)je einen Widerstand von ca. 10 Kiloohm, und der Kondensator (6) einen kapazitiven Widerstand in der Größenordnung von 100 Mikrofarad hat

6. Niederfrequenz-Leitungsempfänger wie in Anspruch 1 definiert, **dadurch gekennzeichnet, dass** der Verstärker (60) mit dem Verstärkungsfaktor 1 umfasst:
einen dritten Operationsverstärker mit einer invertierenden Eingangsklemme, eine nichtinvertierenden Eingangsklemme und eine Ausgangsklemme, wobei die nichtinvertierende Eingangsklemme des dritten Operationsverstärkers an die Eingangsklemme des Verstärker mit dem Verstärkungsfaktor 1 angeschlossen ist und wobei die Ausgangsklemme des dritten Operationsverstärkers an die invertierende Eingangsklemme des dritten Operationsverstärkers und an die Ausgangsklemme des Verstärkers mit dem Verstärkungsfaktor 1 angeschlossen ist.

7. Niederfrequenz-Leitungsempfänger wie in Anspruch 2 definiert, wobei der erste Kondensator (C1) bemessen ist zu bewirken, dass der Niederfrequenz-Leitungsempfänger eine Eingangsimpedanz aufweist, die größer als der Widerstand der ersten und zweiten Vorspannungswiderstände (R1,R3) bei Frequenzen oberhalb der vorbestimmten Frequenz ist, und der zweite Kondensator (C2) bemessen ist zu bewirken, dass der Niederfrequenz-Leitungsempfänger eine Eingangsimpedanz aufweist, die größer als der Widerstand der dritten und vierten Vorspannungswiderstände (R2,R4) bei Frequenzen oberhalb der vorbestimmten Frequenz ist.

8. Niederfrequenz-Leitungsempfänger wie in Anspruch 2 definiert, **dadurch gekennzeichnet, dass** der erste Vorspannungswiderstand (R1;R3) einen Widerstand von ca. 25 Kiloohm aufweist, der zweite Vorspannungswiderstand (R2;R4) einen Widerstand von ca. 25 Kiloohm, und der Kondensator (C1;C2) hat einen kapazitiven Widerstand von ca. 65 Mikrofarad.

9. Niederfrequenz-Leitungsempfänger wie in Anspruch 1 oder Anspruch 2 definiert, **dadurch gekennzeichnet, dass** die vom Leitungsempfänger zurückgewiesenen Gleichtaktsignale im wesentlichen Harmonische einer Netzleitungsfrequenz von im wesentlichen 60 Hertz sind.

## Revendications

1. Un récepteur (62) de ligne audio destiné à recevoir un signal d'entrée en mode différentiel émanant d'une première et d'une deuxième ligne différentielle et à émettre un signal de sortie se rapportant à une référence de terre locale sur une ligne de sortie, ce receveur de ligne audio comprenant:
un amplificateur différentiel (46) ayant une première et une deuxième borne d'entrée (64,66) et une borne de sortie (OUT), la borne de sortie de l'amplificateur différentiel (46) étant connectée à la ligne de sortie; et
un amplificateur d'étage de gain (45) ayant une première et une deuxième borne d'entrée différentielle (IN+, IN-) et une première et une deuxième borne de sortie différentielle, la première borne de sortie différentielle étant accouplée à la première borne d'entrée (64) de l'amplificateur différentiel (46) et la deuxième borne d'entrée différentielle étant accouplée à la deuxième borne de sortie différentielle étant accouplée à la deuxième borne d'entrée (66) de l'amplificateur différentiel; **caractérisé en ce que**
la première borne d'entrée différentielle (IN+) est connectée en courant continu à la première ligne différentielle et la deuxième borne d'entrée différentielle (IN-) est connectée en courant continu à la deuxième ligne différentielle, de sorte que l'amplificateur d'étage de gain (45) fournit à chaque borne d'entrée (IN+, IN-) un trajet de courant continu vers une borne de terre suffisante pour accommoder un courant de polarisation et, de chacune de ses sorties, un trajet de rétroaction en courant alternatif de mode commun par une partie de ce trajet de courant continu vers la terre, ce trajet de rétroaction en courant alternatif fournissant une impédance à haut rendement aux signaux en courant alternatif de mode commun au-dessus d'une fréquence prédéterminée, de façon à ce que les impédances d'entrée en mode commun du récepteur de ligne soient effectivement plus importantes pour les signaux en courant alternatif de mode commun au-dessus de la fréquence prédéterminée que pour les signaux de mode commun en courant continu; ce qui fait qu'au-dessus de la fréquence prédéterminée, le récepteur de ligne reçoit le signal d'entrée en mode différentiel et rejette substantiellement tout signal en mode commun reçu avec le signal d'entrée différentiel;
dans lequel l'amplificateur d'étage de gain (45) comprend:
un premier et un deuxième amplificateur (A7;A7) ayant chacun une borne de sortie, une borne d'entrée inverseuse et une borne d'entrée non-inverseuse, la borne d'entrée non-inverseuse de l'amplificateur (A7) de la première opération étant connectée à la première borne d'entrée différentielle, la borne d'entrée non-inverseuse de l'amplificateur (A7) de la deuxième opération étant connectée à la deuxième borne d'entrée différentielle, la borne de sortie du premier amplificateur opérationnel (A7) étant connectée à la première borne de sortie différentielle, et la borne de sortie du deuxième amplificateur opérationnel (A7) étant connecté à la deuxième borne de sortie différentielle;
le premier, le deuxième et le troisième résisteur de gain (R15, R16, R15), et le premier résisteur de gain (R15) sont connectés d'une part à la sortie et d'autre part à l'entrée inverseuse du premier amplificateur opérationnel (A7), le deuxième résisteur de gain (R15) étant connecté d'une part à la sortie et d'autre part à l'entrée inverseuse du deuxième amplificateur opérationnel (A7) et le troisième résisteur de gain (R16) étant connecté d'une part aux entrées inverseuses du premier et du deuxième amplificateur opérationnel (A7; A7);
le premier et le deuxième résisteur de polarisation (R21, R22) sont connectés sériellement entre la première et la deuxième borne d'entrée différentielle;
un troisième résisteur de polarisation (R25) connecté d'une part à la borne de terre et d'autre part au noeud entre le premier et le deuxième résisteur de polarisation (R21,R22) est prévu pour fournir le trajet du courant continu de la première et deuxième borne d'entrée différentielle à la borne de terre; le quatrième et le cinquième résisteur de polarisation (R23, R24) sont connectés sériellement entre la première et la deuxième borne de sortie différentielle;
un amplificateur à gain unité (60) ayant une borne d'entrée et une borne de sortie, la borne d'entrée de l'amplificateur à gain unité (60) étant connecté à un noeud entre le quatrième et le cinquième résisteur de polarisation (R23, R24); et
un condensateur (C3) connecté d'une part à la borne de sortie de l'amplificateur à gain unité (60) et d'autre part au noeud entre le premier, le deuxième et le troisième résisteurs de polarisation (R21,R22,R25), le condensateur étant prévu d'une taille pour avoir une impédance moindre que la résistance du troisième résisteur de polarisation (R25) à des fréquences dépassant la fréquence prédéterminée.

2. Un récepteur de ligne audio (50) pour recevoir un signal d'entrée en mode différentiel émanant d'une première et deuxième ligne différentielle et pour émettre un signal de sortie se rapportant à une référence de terre locale sur une ligne de sortie, le récepteur de la ligne audio comprenant:
un amplificateur différentiel (32) ayant une première et une deuxième borne d'entrée (56, 58) et une borne de sortie (OUT), la borne de sortie de l'amplificateur différentiel (32) étant connectée à la ligne de sortie; et
un amplificateur d'étage de gain (52,54) ayant une première et une deuxième borne d'entrée différentielle (IN+, IN-) et une première et une deuxième borne de sortie différentielle, la première borne de sortie différentielle étant accouplée à la première borne d'entrée (56) de l'amplificateur différentiel (32) et la deuxième borne de sortie étant accouplée à la deuxième borne d'entrée (58) de l'amplificateur différentiel; **caractérisé en ce que**
la première borne d'entrée différentielle (IN+) est connectée en courant continu à la première ligne différentielle et la deuxième borne d'entrée différentielle (IN-) est connectée en courant continu à la deuxième ligne différentielle, de sorte que l'amplificateur d'étage de gain (52, 54) fournit à chaque borne d'entrée (IN+, IN-) un trajet de courant continu à une borne de terre suffisante pour accommoder un courant de polarisation et un trajet de rétroaction en courant alternatif de chacune de ses sorties en mode commun passant par une partie de ce trajet de courant alternatif vers la terre, le trajet de rétroaction en courant alternatif fournissant une haute impédance d'entrée à des signaux de mode commun en courant alternatif au-dessus d'une fréquence prédéterminée, de façon à ce que les impédances d'entrée de mode commun du récepteur de ligne soient effectivement plus importants pour les signaux en courant alternatif de mode commun qui se trouvent être au-dessus de la fréquence prédéterminée, de sorte que les impédances d'entrée en mode commun du récepteur de ligne soient effectivement plus importants pour les signaux de mode commun en courant au-dessus de la fréquence prédéterminée que pour les signaux de mode commun; faisant que, une fois la fréquence prédéterminée dépassée, le récepteur de ligne reçoit le signal d'entrée en mode différentiel et rejette substantiellement tout signal en mode commun reçu avec le signal d'entrée en mode différentiel;
dans lequel l'amplificateur d'étage de gain comprend:
un premier et un deuxième amplificateur à gain unité (A8, A5), ayant chacun une borne d'entrée et une borne de sortie, les bornes d'entrée du premier et du deuxième amplificateur de gain unité étant directement connectés à la première et la deuxième borne d'entrée, respectivement, de l'amplificateur d'étage de gain, et les bornes de sortie du premier et deuxième amplificateur d'étage de gain étant directement connectées à la première et la deuxième borne de sortie respectivement de l'amplificateur d'étage de gain;
un premier et un deuxième résisteur de polarisation (R1,R3) directement connectés sériellement entre la première borne d'entrée de l'amplificateur d'étage de gain et une borne de terre pour fournir un trajet de courant continu de la première borne d'entrée à la borne de terre;
un troisième et un quatrième résisteur de polarisation (R2, R4) connectés directement et sériellement d'une part à la deuxième borne d'entrée de l'amplificateur d'étage de gain et d'autre part à la borne de terre pour fournir un trajet de courant continu de la borne de terre; et
un premier condensateur (C1) connecté d'une part à la première borne de sortie de l'amplificateur d'étage de gain et d'autre part à un noeud entre le premier et le deuxième résisteur (R1, R3), et un deuxième condensateur (C2) accouplé à la deuxième borne de sortie de l'amplificateur d'étage de gain d'une part et à un noeud entre le troisième et le quatrième résisteur de polarisation (R2, R4).

3. Un récepteur de ligne audio selon la revendication 1 ou 2, **caractérisé en ce que** l'amplificateur d'étage de gain fournit de surcroît de l'énergie électrique en courant continu à ses première et deuxième bornes d'entrée différentielle.

4. Un récepteur de ligne audio selon la revendication 1, **caractérisé par le fait que** l'amplificateur d'étage de gain comprend:
une source d'énergie en courant continu (PSI) connectée à la borne de terre;
le troisième résisteur de polarisation (R25) est connecté sériellement à la source d'énergie en courant continu (PSI) entre la borne de terre et un noeud se trouvant entre le premier et le deuxième résisteur de polarisation (R21, R22) pour fournir le trajet de courant continu provenant de la première et la deuxième borne d'entrée différentielle à la borne de terre au moyen de la source d'énergie en courant continu et pour fournir l'énergie électrique en courant continu au niveau de la première et la deuxième borne d'entrée.

5. Un récepteur de ligne audio selon la revendication 1, **caractérisé en ce que** le premier, le deuxième et le troisième résisteur de polarisation (R21, R22, R25) ont chacun une résistance d'à peu près 10 kilohms, et que le condensateur (6) a une capacité de l'ordre de 100 microfarads.

6. Un récepteur de ligne audio selon la revendication 1, **caractérisé en ce que** l'amplificateur de gain unité (60) comprend:
un troisième amplificateur opérationnel ayant une borne d'entrée inverseuse, une borne entrée non-inverseuse et une borne de sortie, la borne d'entrée non-inverseuse du troisième amplificateur opérationnel est connectée à la borne d'entrée de l'amplificateur de gain-unité et la borne de sortie des troisièmes amplificateurs opérationnels est connectée à la borne d'entrée inverseuse du troisième amplificateur opérationnel et à la borne de sortie de l'amplificateur de gain-unité.

7. Un récepteur de ligne audio selon la revendication 2, dans lequel le premier condensateur (C1) est prévu de taille à causer le récepteur de la ligne audio à avoir une impédance d'entrée plus grande que la résistance des premier et deuxième résisteurs de polarisation (R1,R3) à des fréquences au-dessus d'une fréquence préalablement déterminée, et le deuxième condensateur (C2) est prévu de taille à causer le récepteur de la ligne audio à avoir une impédance d'entrée supérieure à la résistance des troisième et quatrième résisteurs de polarisation (R2, R4) à des fréquences supérieures à une fréquence prédéterminée.

8. Un récepteur de ligne audio selon la revendication 2, **caractérisé en ce que** le premier résisteur de polarisation (R1; R3) a une résistance d'environ 25 kilohms, le deuxième résisteur de polarisation (R2; R4) a une résistance d'environ 25 kilohms et le condensateur (C1; C2) a une capacité d'environ 65 microfarads.

9. Un récepteur de ligne audio selon la revendication 1 ou 2, **caractérisé en ce que** les signaux en mode commun substantiellement rejetés par le récepteur de ligne sont des signaux harmoniques d'une fréquence de ligne d'énergie de substantiellement 60 hertz.
